# EUROPEAN PATENT SPECIFICATION

(11) **EP 1 925 031 B1**
(45) Date of publication and mention of the grant of the patent: **04.05.2016**
(21) Application number: 06789792.6
(22) Date of filing: 17.08.2006
(51) Int. Cl.: H01L 27/146

(54) **HIGH DYNAMIC RANGE / ANTI-BLOOMING COMMON GATE ON MULTI-WAY SHARED PIXELS**
GEMEINSAMES GATE MIT HOHEM DYNAMIKUMFANG BZW. ANTI-BLOOMING AN GEMEINSAM BENUTZTEN MEHRWEGE-PIXELN
GRILLE COMMUNE ANTI-SATURATION / A PLAGE DYNAMIQUE ELEVEE SUR DES PIXELS MULTIVOIE PARTAGES

(30) Priority: 22.08.2005 US 207744
(43) Date of publication of application: 28.05.2008
(73) Proprietor: Aptina Imaging Corporation, Grand Cayman, KY1-9002 (KY)
(72) Inventor: MCKEE, Jeffrey A., Meridian, ID 83642 (US); SHAH, Joey, Thousand Oaks, CA 91320 (US)
(74) Representative: Clarke, Geoffrey Howard
(86) International application number: PCT/US2006/031912
(87) International publication number: WO 2007/024582

(56) References cited:
- JP-A- 5 207 376
- JP-A- 2004 153 253
- US-A1- 2005 110 093

## Description

### FIELD OF THE INVENTION

The present invention relates generally to image sensors and in particular to a pixel array architecture having shared components among pixel cells of the array.

### BACKGROUND OF THE INVENTION

Typically, a digital imager array includes a focal plane array of pixel cells, each one of the cells including a photosensor, e.g. a photogate, photoconductor, or a photodiode. In a CMOS imager a readout circuit is connected to each pixel cell which typically includes a source follower output transistor. The photosensor converts photons to electrons which are typically transferred to a floating diffusion region connected to the gate of the source follower output transistor. A charge transfer device (e.g., transistor) can be included for transferring charge from the photosensor to the floating diffusion region. In addition, such imager cells typically have a transistor for resetting the floating diffusion region to a predetermined charge level prior to charge transference. The output of the source follower transistor is gated as a pixel output signal by a row select transistor.

Exemplary CMOS imaging circuits, processing steps thereof, and detailed descriptions of the functions of various CMOS elements of an imaging circuit are described, for example, in U.S. Patent No. 6,140,630, U.S. Patent No. 6,376,868, U.S. Patent No. 6,310,366, U.S. Patent No. 6,326,652, U.S. Patent No. 6,204,524, and U.S. Patent No. 6,333,205, each assigned to Micron Technology, Inc.

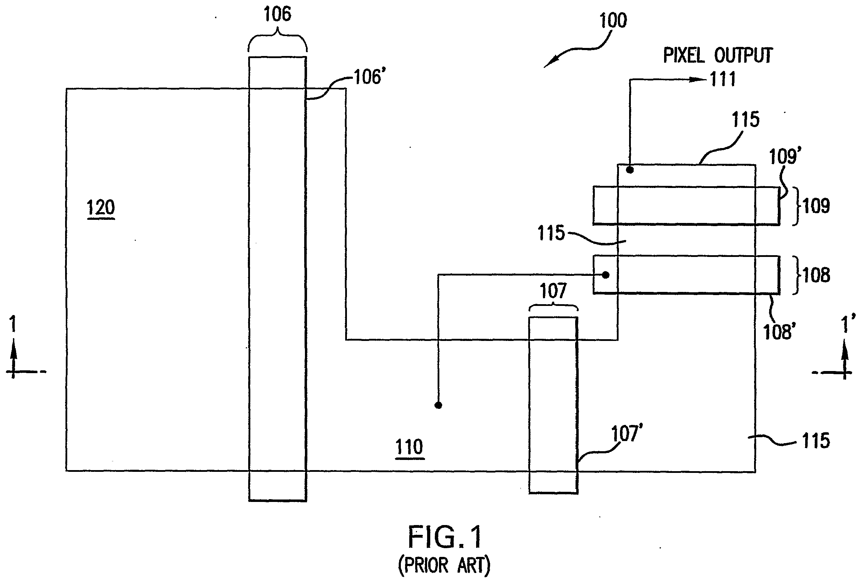

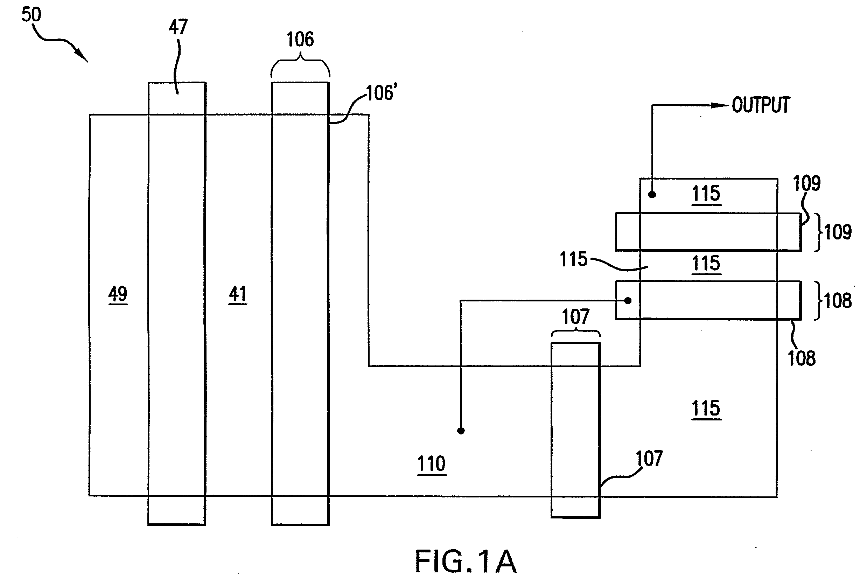

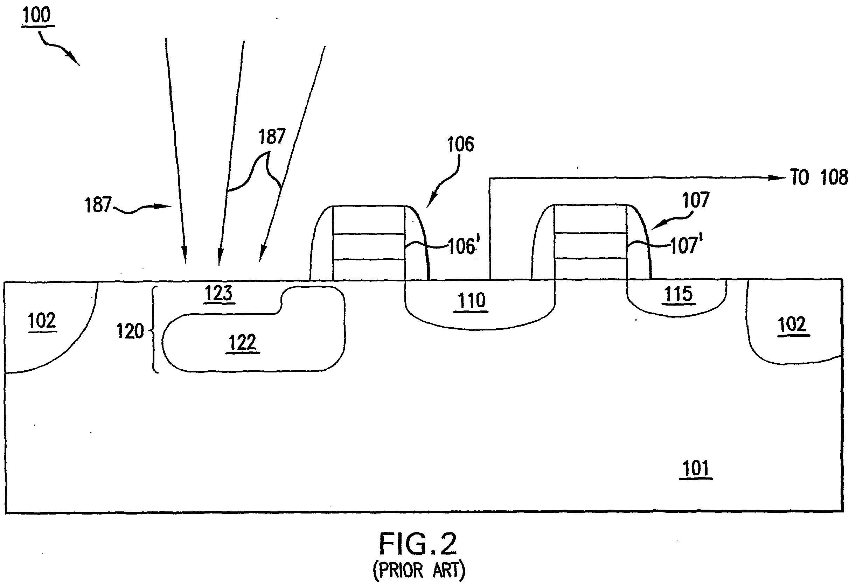

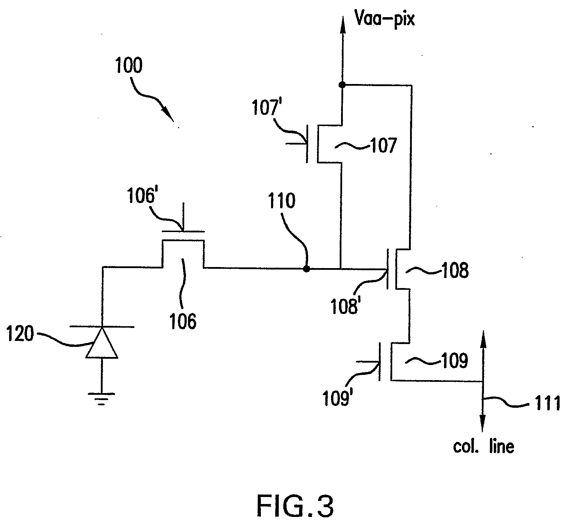

With reference to FIGS. 1, 2 and 3, which respectively illustrate a top-down view, a partial cross-sectional view and electrical circuit schematic of a conventional CMOS pixel 100, when incident light 187 strikes the surface of a photosensor 120, for example, photodiode, electron/hole pairs are generated in the p-n junction of the photodiode (represented at the boundary of n-type accumulation region 122 and p-type surface layer 123). The generated electrons (photo-charges) are collected in the n-type accumulation region 122 of the photodiode, photosensor 120. The photo-charges move from the initial charge accumulation region 122 to a floating diffusion region 110 via a transfer transistor 106. The charge at the floating diffusion region 110 is typically converted to a pixel output voltage by a source follower transistor 108 and subsequently output on a column output line 111 via a row select transistor 109.

Conventional CMOS imager designs, such as that shown in FIG. 1 for pixel 100, provide only approximately a fifty percent fill factor, meaning only half of the pixel 100 is utilized in converting light to charge carriers. As shown, only a small portion of the cell 100 comprises the photosensor 120. The remainder of the pixel 100 includes the isolation regions 102, shown as STI regions in a substrate 101, the floating diffusion region 110 coupled to a transfer gate 106' of a transfer transistor 106, and source/drain regions 115 for reset 107, source follower 108, and row select 109 transistors having respective gates 107', 108', and 109'. As the total pixel area continues to decrease (due to desired scaling), it becomes increasingly important to create high sensitivity photosensors that utilize a minimum amount of surface area or to find more efficient layouts on the pixel array for the non-photosensitive components of the pixel cells to provide increased photosensor areas.

In addition, image sensors, such as an image sensor employing the conventional pixel 100, have a characteristic dynamic range. Dynamic range refers to the range of incident light that can be accommodated by an image sensor in a single frame of pixel data. It is desirable to have an image sensor with a high dynamic range to image scenes that generate high dynamic range incident signals, such as indoor rooms with windows to the outside, outdoor scenes with mixed shadows and bright sunshine, night-time scenes combining artificial lighting and shadows, and many others.

The dynamic range for an image sensor is commonly defined as the ratio of its largest non-saturating signal to the standard deviation of its noise under dark conditions. The dynamic range is limited on an upper end by the charge saturation level of the sensor, and on a lower end by noise imposed limitations and/or quantization limits of the analog-to-digital converter used to produce the digital image. When the dynamic range of an image sensor is too small to accommodate the variations in light intensities of the imaged scene, e.g. by having a low saturation level, image distortion occurs. Accordingly, pixel cells having a high dynamic range are desirable in many instances.

A related problem associated with charge generation in conventional pixels, such as pixel 100, occurs when the incident light captured and converted into charge during an integration period is greater than the capacity of the photosensor 120. A pixel's maximum charge capacity may be reached at a relatively low level of illumination, which causes the pixel 100 to be easily saturated, thereby limiting the dynamic range of the pixel 100. Once the sensing region (photodiode photosensor 120) reaches saturation, any additional photon-to-charge conversion will require some charge leakage to escape the charge accumulation region 122 of the photosensor 120. Often times this leakage causes charges to migrate to undesirable parts of the pixel 100 or onto adjacent pixels, thereby causing cross-talk.

Additionally, when the charges generated during an integration period are output from the photosensor 120 during charge transfer, a small amount of charge may be left over in the photosensor 120. The residual charge may cause the photosensor 120 to exceed its maximum capacity during an integration period, thereby causing excess charge to overflow to adjacent pixels, similar to that just described. This undesirable phenomenon is known as "blooming" and results in a aberration in the resultant output image.

One solution that has been suggested to overcome the above blooming problems, is to provide a pixel 50 with an anti-blooming transistor 47, as shown in FIG. 1A, which is a top-down view of the suggested pixel 50. As shown in FIG. 1A, the pixel 50 is similar to the 4T pixel 100 of FIGS. 1,2, and 3, but has an additional transistor 47, for reducing the blooming phenomenon just described. During an integration period for the pixel 50, when the photosensitive region 41 (which may be any of a photodiode, photogate, or photoconductor) becomes saturated with charge, the anti-blooming (AB) transistor 47 transfers some of the excess charge to a drain area 49 associated with the AB transistor 47 and which drain area is coupled to a voltage supply. The proposed design is effective for increasing the dynamic range of the cell 50 in comparison to the conventional pixel 100; however, the proposed pixel 50 has a lower fill factor than the conventional pixel 100 since pixel 50 includes another transistor 47, which means that less area of the pixel 50 can be photosensitive.

JP05207376A relates to a solid-state image pickup device and its control method.

Accordingly, there is a desire for an array having pixel cells which have a high dynamic range with minimized blooming effects and an efficient layout to permit a high fill factor. A method of operating such a pixel array is also desired.

### BRIEF SUMMARY OF THE INVENTION

The present invention, in the various exemplary embodiments, provides a pixel array architecture having multiple pixels with shared pixel components. The pixel architecture increases the fill factor, and in turn, the quantum efficiency of the pixel array. The common pixel cell components may be shared by a number of pixels in the array, and may include several components that are associated with the readout of a signal from the pixels as well as a shared gate for providing an anti-blooming characteristic for the pixels.

Aspects of the invention are defined in the appended claims.

### BRIEF DESCRIPTION OF THE DRAWINGS

The foregoing and other aspects of the invention will be better understood from the following detailed description of the invention, which is provided in connection with the accompanying drawings, in which:
FIG. 1 is a top-down view of a conventional four transistor (4T) CMOS pixel;
FIG. 1A is a top-down view of a suggested 5T CMOS pixel including an anti-blooming transistor;
FIG. 2 is a cross-sectional view of the pixel of FIG. 1, taken along line 1-1';
FIG. 3 is a circuit diagram of the conventional CMOS pixel of FIGS. 1 and 2;
FIG. 4 is a top-down view of a portion of a pixel array constructed in accordance with a first exemplary embodiment of the invention;
FIG. 5 is a circuit diagram for a portion of the pixel array constructed in accordance with the first exemplary embodiment of the invention;
FIG. 6 is a timing diagram illustrating an exemplary method of operating a pixel array constructed in accordance with the first exemplary embodiment of the invention;
FIG. 7 is a top-down view of a portion of a pixel array constructed in accordance with a second exemplary embodiment of the invention;
FIG. 8 is a circuit diagram for a portion of the pixel array constructed in accordance with the second exemplary embodiment of the invention;
FIG. 9 is a timing diagram illustrating an exemplary method of operating a pixel array constructed in accordance with the first exemplary embodiment of the invention;
FIG. 10 is a block diagram of a CMOS imager chip having an array of pixel cells constructed in accordance with the invention; and
FIG. 11 is a block diagram of a processing system employing a CMOS imager constructed in accordance with the invention.

### DETAILED DESCRIPTION OF THE INVENTION

In the following detailed description, reference is made to the accompanying drawings, which form a part hereof and show by way of illustration specific embodiments in which the invention may be practiced. The progression of processing steps described is exemplary of embodiments of the invention; however, the sequence of steps is not limited to that set forth herein and may be changed as is known in the art, with the exception of steps necessarily occurring in a certain order.

The terms "wafer" and "substrate," as used herein, are to be understood as including silicon, epitaxial, silicon-on-insulator (SOI) or silicon-on-sapphire (SOS) technology, doped and undoped semiconductors, and other semiconductor structures. Furthermore, when reference is made to a "wafer" or "substrate" in the following description, previous processing steps may have been utilized to form regions, junctions, or material layers in or over the base semiconductor structure or foundation. In addition, the semiconductor need not be silicon-based, but could be based on silicon-germanium, germanium, gallium arsenide or other semiconductors.

The term "pixel," as used herein, refers to a photo-element unit cell containing a photosensor and associated transistors for converting photons to an electrical signal. For purposes of illustration, a small number of representative pixels are illustrated in the figures and description herein; however, typically fabrication of a large plurality of like pixels proceeds simultaneously. Accordingly, the following detailed description is not to be taken in a limiting sense, and the scope of the present invention is defined only by the appended claims.

The terms "at an angle," "angled," and "slanted," as used herein are to be interpreted as meaning at any angle, with respect to some stated reference point, that is not exactly parallel or exactly perpendicular. Accordingly, when at least a portion of an object and some reference point meet to form an angle that is not 0°, 90°, or 180°, the object is considered "angled," "at an angle," or "slanted" with respect to the reference point.

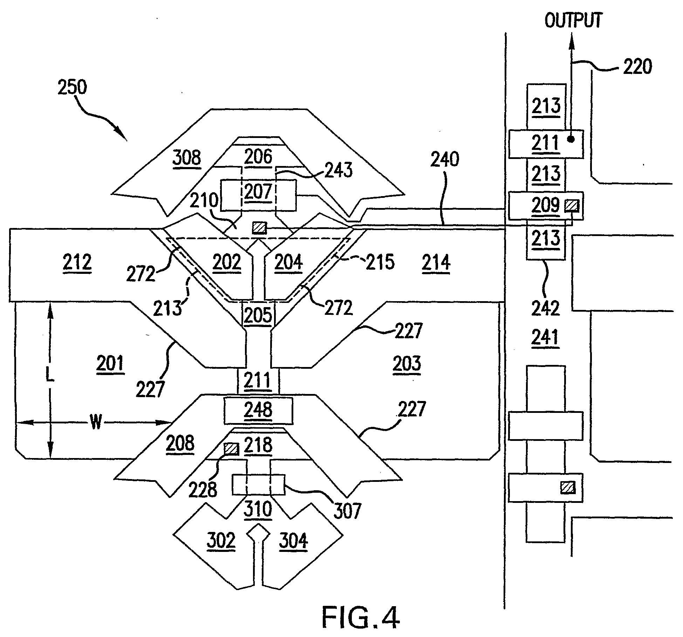

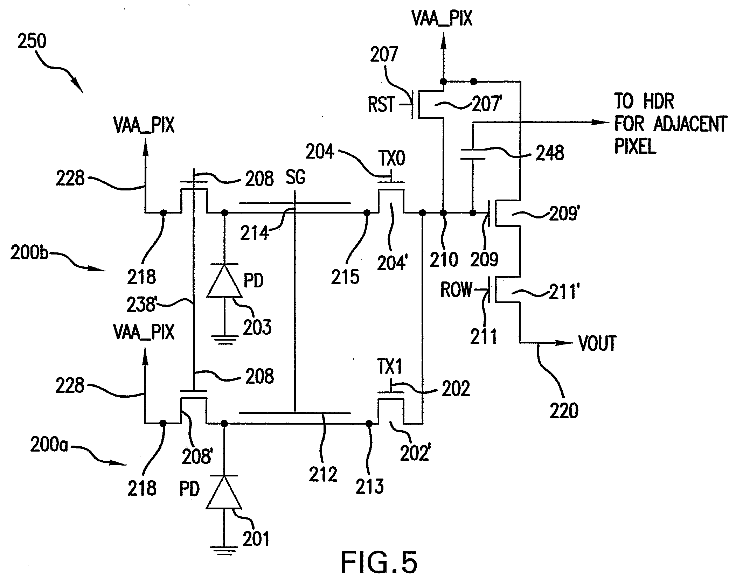

Now referring to the figures, where like numerals designate like elements, FIG. 4 illustrates a top-down view of a portion of a pixel array 250 constructed in and over a silicon substrate with a pixel layout design in accordance with a first exemplary embodiment of the present invention. FIG. 5 is a circuit diagram depicting portions of the FIG. 4 pixel array 250.

In the illustrated portions of pixel array 250, two row-adjacent pixels 200a, 200b having photosensors 201, 203 share common pixel components, including a common high dynamic range/anti-blooming gate 208, as discussed in more detail below. The photosensors 201, 203, may be any photosensitive structure for converting light photons into electrons (photo-charges), and in a preferred embodiment, the photosensors 201, 203 are photodiode regions. Each photosensor 201, 203 illustratively has an associated storage gate 212, 214 for storing the generated photo-charges in respective storage regions 213, 215 prior to a readout of the charges. The storage gates 212, 214 and associated storage regions 213, 215 increase the charge capacity of the pixels in array 250. It should be understood that the storage regions primarily comprise a doped region (n-type) located under the respective storage gates 212, 214 in the substrate.

In addition, the storage regions 213, 215 can also be utilized to store a first pixel signal from a first integration period while the photosensors 201, 203 are generating photo-charges during a second integration period. It should be understood that if ample charge storage capacity is not an issue for an imager implementing the invention, the storage gates 212, 214 can be removed from the layout in order to maximize the imager's photosensitive area, by maximizing the size of the photosensors 201, 203 for each shared pixel 200a, 200b in the array 250.

Each pixel 200a, 200b has a respective transfer gate 202, 204 as part of a respective transfer transistor 202', 204' for transferring the accumulated photos-charges from the photosensors 201, 203 to a common storage node, shown as floating diffusion region 210. If the storage gates 212, 214 are utilized, the transfer transistors 202', 204' transfer charges from charge storage regions 213, 215 under the storage gates 212, 214 to the shared floating diffusion region 210 through the respective transfer gates 202, 204. As shown, the individual transfer gates 202, 204 may be replaced by one shared transfer gate 205, as illustrated by the dashed lines in FIG. 4. In the case of a shared transfer gate 205, the resolution of the pixel array 250 might be slightly decreased, as only one signal is generated for the two row adjacent photosensors 201, 203.

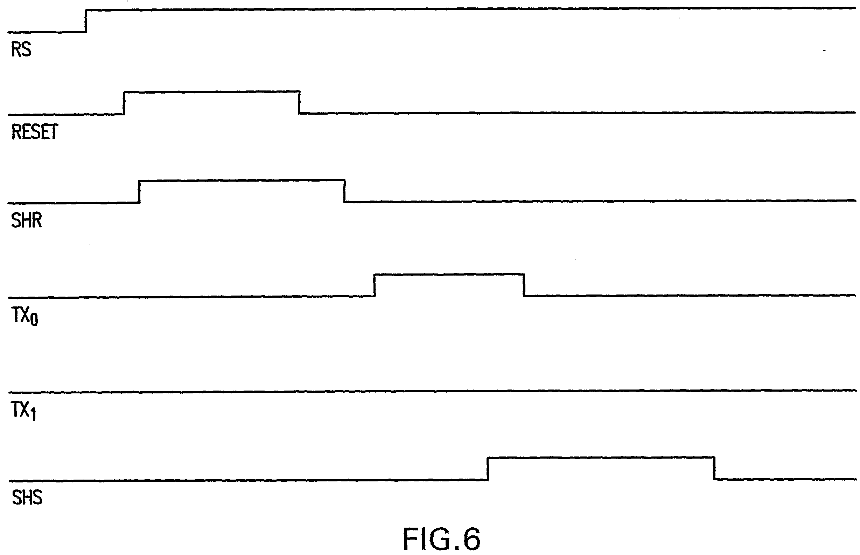

The use of storage gates 212,214 in association with storage regions 213, 215 are optional, however, they permit a readout operation, discussed below with reference to FIG. 6, to occur during the integration time for a next frame of an image without the need for a mechanical shutter. Specifically, the storage gates 212, 214 transfer the charges generated by the photosensors 201, 203 during an integration period into an associated storage region 213, 215, where they can be stored and read out during the next integration period. Thus, while the photosensors 201, 203 are generating charge, a read out operation can be initiated by transferring the previously generated charges from the storage regions 213, 215 to the shared floating diffusion region 210.

Preferably, each of the storage gates 212, 214 (if used) and transfer gates 202, 204 have at least a portion of the gate that is angled with respect to the associated photosensors 201, 203. For example, the edges 227 of the storage gates 212, 214 are shown as being slanted with respect to the length L and the width W of the associated photosensors 201, 203. Similarly, each of the transfer gates 202, 204 (or 205) has an edge 272 that is similarly slanted with respect to the length L and the width W of the photosensors 201, 203. This preferred angled geometry of the gates 212, 214, 202, 204 (and/or 205) allows for an efficient layout of the gates 212, 214, 202, 204 (and/or 205), to improve the leakage and lag performance of the pixels 200a, 200b in array 250. In addition, this angled layout is also beneficial in maximizing the fill factor of the pixels 200a, 200b in array 250, by maximizing the area of the photosensors 201, 203.

In accordance with the invention, the shared HDR/AB gate 208 is provided to drain excess charges away from the photosensors 201, 203. One side of the shared HDR/AB gate 208 is located adjacent the photosensors 201, 203, forming HDR/AB transistors 208', 238'. Preferably, as shown, at least a portion of an edge 227 of the HDR/AB gate 208 is formed at an angle with respect to the photosensors 201, 203, as to maximize photosensitive area of the array 250. On the other side of the HDR/AB gate 208 is a drain region 218, into which the HDR/AB gate 208 drains charges. The drain region 218 is connected to an array pixel voltage Vₐₐ₋ₚᵢₓ at connection 228. It should be noted the drain region 218 is also a drain for a reset transistor gate 307, which is used for resetting floating diffusion region 310 in an adjacent row of array 550. This layout minimizes the non-photosensitive areas of the array 250, by increasing the size of the photosensors 201, 203.

The degree of leakage from photosensors 201, 203 to the drain region 218 through the shared HDR/AB gate 208 depends upon many factors, including the threshold voltage characteristics of the HDR/AB transistors 208', 238' and the voltage applied to the gate 208 of the HDR/AB transistors 208', 238'. It should be understood that these factors can be adjusted, as desired, to optimize the functioning of an imager 1300 implementing the shared HDR/AB gate 208. For example, although the operation of the HDR/AB gate 208 may be done globally for every pixel in array 250, a circuit can be implemented to adjust the operating parameters of the HDR/AB transistors 208', 238' as will be described herein. In addition, the doping profile of the substrate beneath the HDR/AB gate 208 can be fabricated as desired to modify the threshold voltage of the HDR/AB transistors 208', 238' depending on the optimal performance of the transistors 208', 238'.

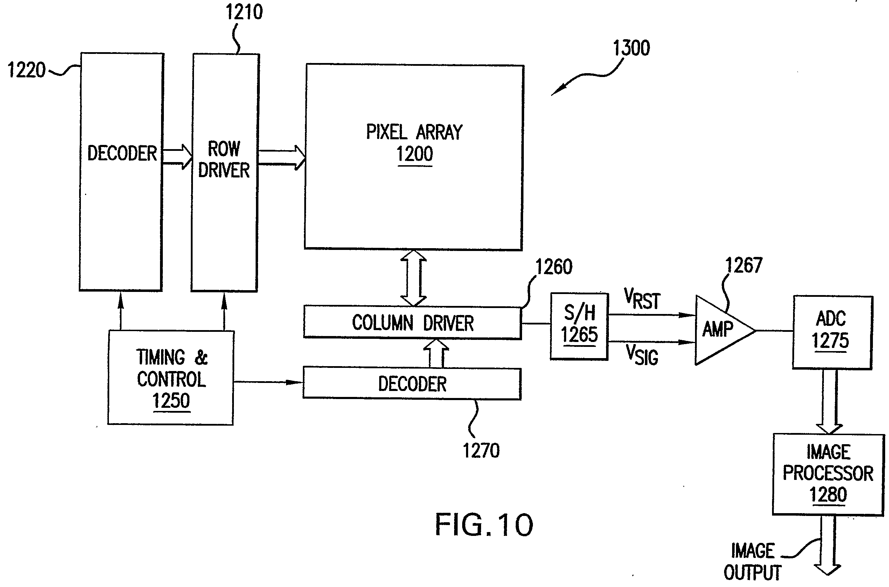

In one operational aspect, the HDR/AB transistors 208', 238' operates as a global reset for the array, permitting a frame shutter operation. Typically, CMOS pixel sensors (e.g., pixel 100 of FIGS. 1-3), are operated using a "rolling" shutter. A rolling shutter operates by reading out each row of pixels sequentially, and hard resetting a readout row in advance of the readout row by a number of rows corresponding to an integration period, before moving to the next row for performing readout and another hard reset in advance by the number of rows equal to an integration period. Thus, each pixel has an equivalent integration period, however, the integration periods for the rows may have significantly different start and end times which might cause image blur for fast moving objects in an imager. Some pixel imager applications may require more time consistency among integration times than is possible using the rolling shutter approach. Therefore, using the HDR/AB transistors 208', 238' as a global reset for each photosensor 201, 203 of the array 250, may be beneficial. In this way, an integration period begins by resetting the photosensors 201, 203 through the HDR/AB gate 208 by applying a voltage V_{HDR} to the gate 208 that is greater than its threshold voltage for the transistors 208', 238' causing a hard reset of the photosensors 201, 203, etc., all at once. Thus, any charges residing on the photosensors 201, 203 will drain to the drain region 218 through the HDR/AB transistors 208', 238'. As the imager's timing and control circuitry 1250 (FIG. 10) can coordinate the application of a voltage V_{HDR} to every HDR/AB gate 208 of an array 250 simultaneously, each of the photosensors 201, 203 of the array 250 will have an integration period beginning at the same time, without the need for a rolling shutter. The voltage applied to the HDR/AB gate 208 once decreased, allows the photosensors 201, 203 to accumulate charge. The storage gates 212, 214 can also be operated on a global basis after the integration period to store photosensor accumulated charges in the storage regions 213, 215 for later read out through the transfer transistors 202, 204.

In accordance with another operational aspect of the invention, the HDR/AB transistors 208', 238' operates as a means for obtaining a high dynamic range for the pixels in array 250 while also preventing blooming. By permitting a certain amount of charge on the photosensors 201, 203 to drain into drain region 218 during charge integration, the photosensors 201, 203 will saturate at a higher level of illumination in comparison to the conventional photosensor 120, thereby providing an increased dynamic range. This, in turn, advantageously permits the imaging of scenes having varied light intensities using pixel array 250 and mitigates blooming into undesirable locations of the pixel array 250. The particular voltage applied for optimizing the anti-blooming characteristics will be somewhere between 0.0 V and the operating voltage applied to either the storage gates 212, 214 or the transfer gates 202, 204, if the storage gates 212, 214 are not used. The applied voltage decreases the potential difference between the photosensors 201, 203 and the drain region 218 to control the movement of excess photo-charges into the drain region 218.

In accordance with another operational aspect of the invention, a shared capacitor 248 may be constructed utilizing the shared HDR/AB gate 208 as one electrode of the capacitor. As such, the capacitance of each pixel 200a, 200b can be increased by storing excess charge in the capacitor 248, so long as the voltage applied to the HDR/AB gate does not cause these excess charges to drain into the common drain region 218. A second electrode of the capacitor 248 is electrically connected to a gate of a source follower transistor for an adjacent pair of pixels. This capacitor 248 is optional, and is not necessary if the pixels 200a, 200b have sufficient capacitance.

The remaining pixel components are shared between the row adjacent pixels as shown in FIGS. 4 and 5. These components are utilized in readout operations for the array 250. A shared floating diffusion region 210 serves as a common storage node, receiving charges from the photosensors 201, 203 through the transfer gates 202, 204, and optionally the storage gates 212, 214. A reset transistor having a gate 207 is located on a side of the floating diffusion 210 opposite the photosensors 201, 203. A source/drain region 206 on a second side of the reset gate 207 is capable of receiving a supply voltage Vₐₐ₋ₚᵢₓ. The floating diffusion region 210 is also electrically connected to the gate 209 of a source follower transistor 209', which has a drain 213 coupled to the supply voltage Vₐₐ₋ₚᵢₓ. The source follower transistor 209 creates a voltage output signal based on charge stored on the floating diffusion region 210. A row select transistor having a gate 211 has a drain 213 connected to the source of the source follower transistor 209', for selectively reading out the pixel signal to a column line 220.

As shown in FIG. 4, in accordance with a preferred layout for the pixel array 250, the shared readout components are located in a split trunk design. The first trunk 243 includes the floating diffusion region 210, and reset gate 207, which shares a drain region 206 with a shared HDR/AB gate 308 for the adjacent row. The second trunk 242, is physically isolated from the first trunk 243, located in an isolation region 241, adjacent one of the photosensors 203. The second trunk 242 includes the source follower 209' and row select 211' transistors. The second trunk 242 is electrically connected to the first trunk 241 by means of an electrical interconnection 240 which interconnects the floating diffusion region 210 to the gate 209 of the source follower transistor 209'.

Turning to FIG. 6, an exemplary method of operating the pixel array 250 is now described with further reference to FIG. 10, a block diagram of a CMOS imager 1300 incorporating the pixel array 1200 based on exemplary array 250. The exemplary method of operation employs the storage gate 212, 214 feature, as discussed above, which eliminates the need for a mechanical shutter or pulsed light source by allowing pixel signal readout during an integration period. It should be understood, however, that the invention is in no way limited to the use of a storage gate or to the exemplary methods of operation as described herein. For pixel array 250, the integration period for each pixel is defined by the time period between resetting the respective photosensor 201, 203, through HDR/AB gate 208 and transferring the photo-charges from the photosensors 201, 203 through the storage gate 212, 214 to a storage region 213, 215. It should be noted that if a storage gate is not used, the read out operation may involve a rolling shutter.

It is assumed that the integration period for photosensors 201, 203 has occurred, and the generated charges have been transferred from charge accumulation regions in the photosensors 201, 203 to respective storage regions 213, 215. As shown in FIG. 6, a row select gate 211 is turned "on" by the timing and control circuitry 1250 (FIG. 10) by asserting a high row select signal RS. The reset gate 207 is turned on, by pulsing the Reset signal to high, which creates a reset condition for the floating diffusion region 210. Next, the circuitry 1250 pulses a sample and hold reset (SHR) signal high to initiate readout of a reset signal Vᵣₛₜ from the pixel. The reset (Reset) and sample hold reset (SHR) signals are driven low before the transfer gate 204 is turned "on" by driving the appropriate transfer gate signal TX₀. Sometime thereafter, control circuitry 1250 initiates the readout of a pixel signal V_{sig} on the column output line 220 by driving the sample and hold pixel signal (SHS) high. Further signal processing is then performed on the signals as explained in more detail below.

It should be understood that the steps just described would be repeated for the next adjacent pixel except that the transfer signal for this pixel TX1 would go high instead of TX0. This process also repeats row-by-row for every row in the array 250. Thus, for every other pixel sensor in a row an even transfer signal (for even numbered columns of the array) TX₀ turns on the even column transfer gates, while an odd transfer signal TX₁ (for odd numbered columns of the array) turns on the odd column transfer gates.

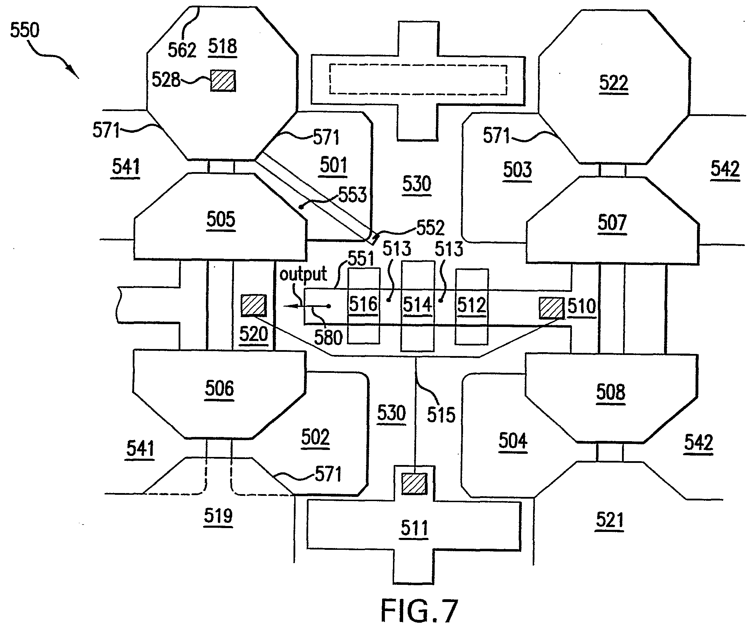

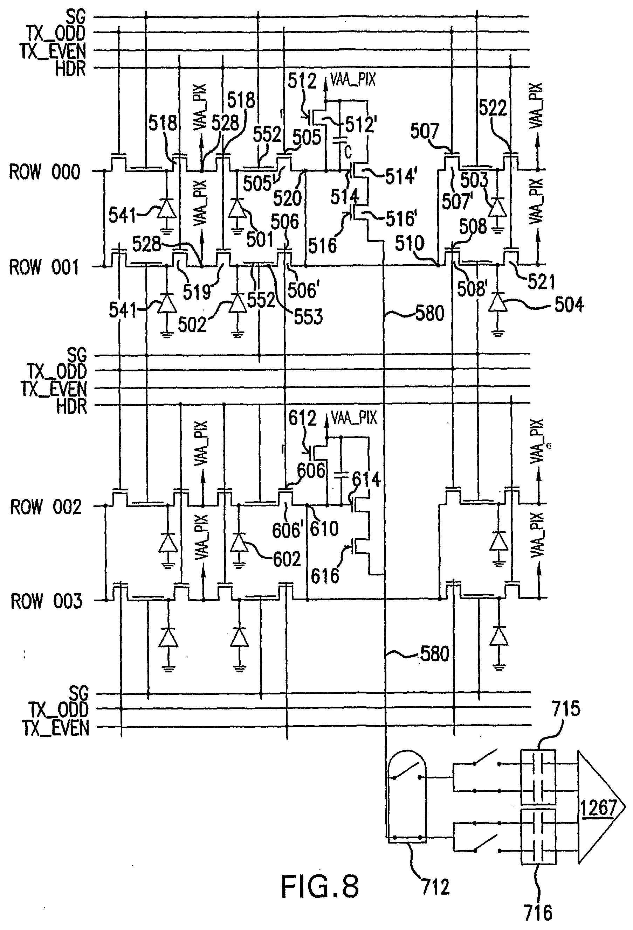

Turning to FIGS. 7 and 8, a second exemplary embodiment of the invention is now described. FIG. 7 illustrates a top-down view of a portion of a pixel array 550 constructed in and over a silicon substrate with a pixel layout design in accordance with a second exemplary embodiment of the present invention. FIG. 8 is a circuit diagram depicting portions of the exemplary pixel array 550 in electronic schematic forms. In accordance with the second exemplary embodiment of the invention, the pixel array 550 architecture includes 4-way sharing of pixel components. The shared components include pixel signal readout components located on a linearly-extending trunk 551 within the area between four photosensors 501, 502, 503, 504. In addition, HDR/AB gates 518,519, 521, 522 are also shared by four pixels in array 550.

As illustrated in FIG. 8, each pixel has a transfer transistor 505', 506' 507', 508' having an associated gate 505, 506, 507, 508. At least a portion of each of the gates 505, 506, 507, 508 is preferably at an angle with respect to the photosensors 501, 502, 503, 504 as shown in FIG. 7. It should be noted that the transfer transistor gates 505, 506, 507, 508 of this embodiment are being shared, each among two row adjacent pixels in array 550. For example, as shown in FIG. 7, row adjacent photosensors 501, 541 may share the transfer transistor gate 505. The two illustrated pixels (having photosensors 501, 541) do not, however, share a floating diffusion region or readout circuit. Rather, this embodiment has two column adjacent pixels having photosensors 501, 502 sharing a first floating diffusion region 520 and two column adjacent photosensors 503, 504 sharing a second floating diffusion region 510. The two floating diffusion regions 510, 520 are electrically connected to one another, either by conductive trace or a doped region in the substrate, and to an associated dual conversion gain gate 511, if desired, through an electrical interconnection 515. For example, the electrical interconnection 515 may be formed in a first metallization layer above the surface of the pixel array 550. The dual conversion gain gate 511 (not shown in FIG. 8) may also serve as an electrode for a capacitor C (FIG. 8). Capacitor C serves to increase the charge storage capacity of the connected floating diffusion regions 510, 520.

As shown in FIG. 8, storage gates 552 (FIG. 8) can also be implemented with this second exemplaty embodiment similar to those described above. Although not shown on evety pixel in array 550 in FIG. 7 for purposes of simplicity, dashed line 552 represents the location of a storage gate, if desired. Each photosensor 501, 502, 503, 504 could have a storage gate located between the photosensor 501, 502, 503, 504 and the associated transfer gate 505, 506, 507, 508. As described above, storage gates, such as storage gate 552, permits the readout from pixels in array 550 during an integration period for an associated photosensor 501, and it eliminates the need for mechanical shutters or pulsed light sources.

One reset transistor 512' having a gate 512 is utilized for resetting charges at both floating diffusion regions 510, 520. To one side of the reset gate 512 is a source/drain region 513 that is capable of receiving a supply voltage Vₐₐ₋ₚᵢₓ. The remaining readout components on the trunk 551 shared among photosensors 501, 502, 503, 504 include a source follower transistor having a gate 514 connected to the floating diffusion regions 510, 520, and a row select transistor having a gate 516. Isolation regions 530 in the substrate are utilized to isolate the active areas on the trunk 551 from the photosensors, and also isolate the individual charge accumulation regions of photosensors 501, 502, 503, 504 from one another. Any known isolation technique, including but not limited to shallow trench isolation (STI), may be used when forming isolation regions 530.

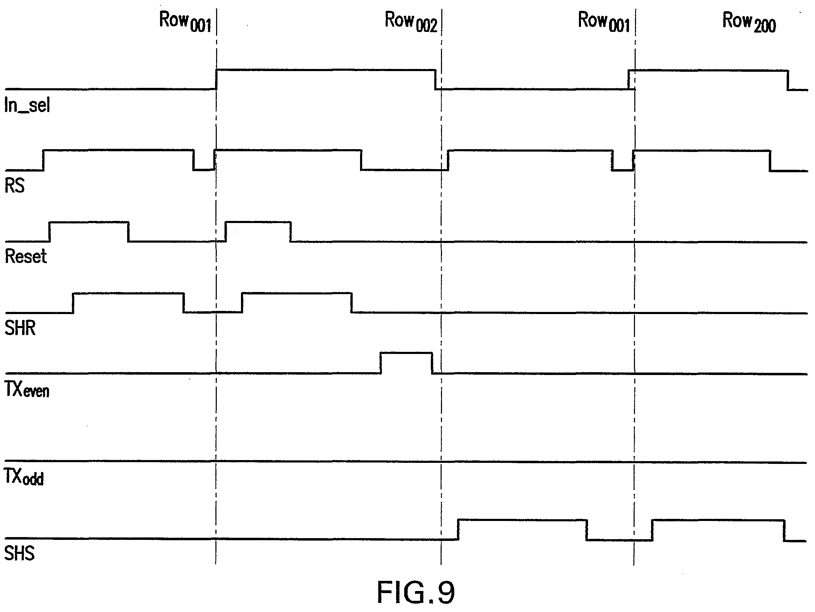

The four-way shared pixel layout described herein illustratively has a first pair of column-adjacent pixels having respective photosensors 501, 502 (FIG. 7) and a second pair of column adjacent pixels having respective photosensors 503, 504 sharing one set of readout circuitry. Thus, a column output line 580 is only necessary, in accordance with this exemplary embodiment, for every other column of a pixel array 550. As such, two column-adjacent pixels will be sequentially read onto the same output line 580 at nearly the same time, and their respective signals need to be separately handled in order to maintain maximum resolution for the pixel array 550. As shown in FIG. 8, this means that each column output line 580 utilizes two sets of sample and hold capacitors 715, 716 (four capacitors total). A switch 712, activated by an in_sel signal (FIG. 9) is utilized to determine whether the incoming signal should go to the first set of capacitors 715 or the second set of capacitors 716). The two pixels that readout signals onto column line 580 do not share the same read out circuitry (such as row select transistor 516), but rather, they share the same transfer gate signal, such as signal TX_EVEN <1> (FIG. 8). The remaining control circuitry (discussed in detail below with reference to FIG. 10) produces a differential signal, for each pixel, from the signals stored in the sets of capacitors 715, 716, which is then output for further processing.

Each HDR/AB gate 518, 519, 521, 522 is shared among, and overlaps corners of, four adjacent pixels. Exemplary HDR/AB gate 518 is located between a first pair of row adjacent photosensors 501, 541 at a lower edge 561 and a second pair of row adjacent photosensors (not shown), which are in an adjacent row, and are located at the same position of the HDR/AB gate 518 on an upper edge 562. Preferably, at least one edge 571 of the HDR/AB gate is located at an angle where it intersects with each of the photosensors 501, 541. As stated above, this angled geometry maximizes the fill factor for each pixel in array 550. Each HDR/AB gate 518, 519, 521, 522 has a connection at one side to a drain region 528. This drain region 528 is connected to a pixel supply voltage Vₐₐ₋ₚᵢₓ, such that the HDR/AB gate 518 can drain excess charges away from the photosensors 501, 541 to the drain region 528. In addition, when a sufficient voltage is supplied to the HDR/AB gates 518, 519, 521,522, the gate can operate to reset the photosensors associated therewith e.g., 501, 502, 503, 504.

In an exemplary method of operating the pixel array 550, storage gate (SG) and high dynamic range (HDR) gate signals operate globally throughout all of the rows in a pixel array 550. An integration period for each of the photosensors (such as 501, 502, 503, 504) begins by resetting the photosensor through the respective HDR/AB gates 518, 519, 521, 522. The integration time ends for each of the pixels when the charges generated in the photosensors 501, 502, 503, 504 are transferred to a storage region 553 through a storage gate 552. If a storage gate 552 is utilized with the invention, pixel readout can occur during a next integration time for the array 550, as the charges from a previous integration time are stored in a storage region 553.

The steps for pixel readout will now be described. It should be noted that the transfer gate signal lines TX_ODD, TX_EVEN, shown in FIGS. 8 and 9, use nomenclature where ODD or EVEN represent the odd or even pixel columns in an array. Further, the nomenclature Rowₓₓₓ is used to designate row number "xxx" of the array.

With reference to FIG. 9, for a row Row₀₀₁ of the array 550 containing photosensors 502, 504, a row select transistor 516 is activated by turning a row select signal (RS) high. A reset of the floating diffusion region 510 is performed by activating reset gate 512 with reset signal Reset. A signal Vᵣₛₜ representing the reset condition is read out onto column line 580 by activating sample and hold reset signal SHR The in_sel signal, described above, is low controlling storage of the signal into one of the two sets of sample and hold capacitors 715, 716 (FIG. 8). Next, for a next row, Row₀₀₂ this same sequence of steps is repeated, turning the appropriate row select (RS), reset (Reset) and sample and hold reset (SHR) signals high for a second row Row₀₀₂ to read out a signal onto the column line 580 for a reset condition of a second photosensor 602 in an adjacent row. This time, however, the in_sel signal is high, causing the signal to be stored in a different of the two sample and hold capacitor sets 715, 716.

Next, a transfer signal TXₑᵥₑₙ is turned to high, to activate the even column transfer transistor gates 506 in two adjacent rows. Charges stored in the storage area 553 are thus transferred through the transfer transistor 506' into a floating diffusion region 510 and similarly for the charges generated by photo-sensors 602 in the next row by turning "on" transfer gate 606. Next, for Row₀₀₁, a pixel voltage signal V_{sig} is read onto the column line 580 by activating the row select transistor 516 turning RS and sample and hold SHS signals to high. This is done while the in_sel signal is low so that the reset signal Vᵣₛₜ for Row₀₀₁ is matched up in a set of sample and hold capacitors 715, 716 with the pixel signal V_{sig} sampled from this row. The row select and sample and hold signals RS and SHS return to low. For Row₀₀₂, a pixel voltage signal V_{sig} is now read out repeating the pulsing of row select (RS) and sample and hold signals (SHS). From floating diffusion region 610, a signal is generated by source follower transistor gate 614, through row select transistor 616 and onto the column line 580. During this readout, however, the in_sel signal is returned to high to store the signal from Row₀₀₂ into the appropriate set of capacitors 715, 716.

This exemplary method is performed simultaneously for every other column in a row, utilizing the alternative transfer gate signal TX_odd to activate transfer transistor gates in odd columns of the array. The method is repeated in this sequence for each pair of rows (Row₀₀₁ and Row₀₀₂) until signals are read out for each pixel in array 550. It should be understood that these steps are meant for exemplary purposes only, and the invention is in no way limited to the method of readout operation as described herein.

FIG. 10 illustrates a block diagram of an exemplary CMOS imager 1300 having a pixel array 1200 being constructed in accordance with one of the embodiments described above. Pixel array 1200 comprises a plurality of pixels arranged in a predetermined number of columns and rows (not shown). Attached to the array 1200 is signal processing circuitry, as described herein, at least part of which may be formed in the substrate. The pixels of each row in array 1200, and/or all of the pixels in a pair of rows in the array 1200, by a row select line, are all turned on at the same time and the pixels of each column are selectively output by respective column select lines. A plurality of row and column lines are provided for the entire array 1200. The row lines are selectively activated by a row driver 1210 in response to row address decoder 1220. The column select lines are selectively activated by a column driver 1260 in response to column address decoder 1270. Thus, a row and column address is provided for each pixel.

The CMOS imager 1300 is operated by the timing and control circuit 1250, which controls address decoders 1220, 1270 for selecting the appropriate row and column lines for pixel readout. The control circuit 1250 also controls the row and column driver circuitry 1210, 1260 such that these apply driving voltages to the drive transistors of the selected row and column lines. The pixel column signals, which typically include a pixel reset signal (Vᵣₛₜ) and a pixel image signal (V_{sig}), are read by a sample and hold circuit 1265 associated with the column device 1260. A differential signal (Vᵣₛₜ - V_{sig}) is produced by differential amplifier 1267 for each pixel which is digitized by analog to digital converter 1275 (ADC). The analog to digital converter 1275 supplies the digitized pixel signals to an image processor 1280 which forms a digital image.

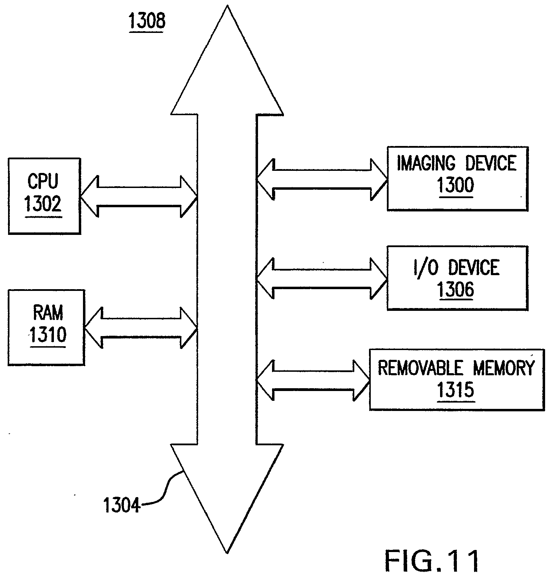

FIG. 11 shows a processor system 1308, which includes an imager 1300 constructed in accordance with an embodiment of the invention. The processor system 1308 may be part of a digital camera or other imaging system. The imager 1300 may receive control or other data from system 1308. System 1308 includes a processor 1302 having a central processing unit (CPU) for image processing, or other image handling operations. The processor 1302 communicates with various devices over a bus 1304. Some of the devices connected to the bus 1304 provide communication into and out of the system 1308; an input/output (I/O) device 1306 and imager 1300 are such communication devices. Other devices connected to the bus 1304 provide memory, for instance, a random access memory (RAM) 1310 or a removable memory 1315.

The processes and devices described above illustrate preferred methods and typical devices of many that could be used and produced. The above description and drawings illustrate embodiments, which achieve the objects, features, and advantages of the present invention. However, it is not intended that the present invention be strictly limited to the above-described and illustrated embodiments. For example, although the invention is discussed only with reference to pixel arrays having a 2-way or 4-way sharing of component parts, other multi-way sharing pixel arrays are also intended to be within the scope of the invention.

## Claims

1. A pixel array (550) comprising:
a first photosensor for generating charge in response to applied light;
a second photosensor for generating charge in response to applied light;
first and second high dynamic range/anti-blooming ("HDR/AB") transistors respectively coupled to the first and the second photosensors for draining the generated charges away from the photosensors to a common drain region (528), said transistors having a common HDR/AB gate (518);
a third photosensor and a fourth photosensor for generating respective charges in response to applied light; and
third and fourth HDR/AB transistors respectively coupled to the third and fourth photosensors for draining the generated charges away from the third and fourth photosensors to said common drain region (528), said third and fourth HDR/AB transistors including said common HDR/AB gate (518).

2. The pixel array of claim 1, wherein at least two of the four photosensors (501, 541; 503, 542) share a common transfer transistor gate (505; 507) for transferring said generated charges to a floating diffusion region (520; 510).

3. The pixel array of claim 2, wherein the common transfer transistor gate (506; 507) is located at a side of the at least two photosensors (501, 541) opposite the common HDR/AB gate (518).

4. The pixel array of claim 1, wherein the first and the second photosensors (501, 541; 503, 542) are row adjacent photosensors in a first row of the array, and wherein the third and the fourth photosensors are row adjacent photosensors in a second row of the array.

5. The pixel array of claim 1, wherein the first, second, third, and fourth photosensors are associated with a respective first, second, third, and fourth readout circuit.

6. A pixel array comprising:
a plurality of pixels arranged into rows and columns, the plurality including:
first, second, third, and fourth pixels having respective first, second third and fourth photosensors (501, 502, 503, 504) for generating photo-charges;
first, second, third, and fourth HDR/AB transistors (518, 519, 522, 521) for draining excess photo-charges from the first, second, third, and fourth photosensors into a drain region (528);
a common storage node (520, 510) for storing the generated photo-charges; and
at least one common transistor for reading out a signal from the common storage node representing an amount of generated photo-charges onto a column line (580).

7. The pixel array of claim 6, further comprising first, second, third, and fourth storage gates for respectively transferring generated charges from the first, second, third, and fourth photosensors into a respective storage region.

8. The pixel array of claim 7, further comprising a respective first, second, third, and fourth transfer transistor (505', 506', 507', 508') for respectively transferring charges from the respective first, second, third, and fourth storage regions into the common storage node.

9. The pixel array of claim 6, further comprising a readout circuit that includes at least two sets of capacitors (715, 716) for storing signals output on the column line.

10. The pixel array of claim 8, further comprising a switch (712) for directing a first signal into a first set of capacitors and a second signal into a second set of capacitors.

11. An imager comprising a pixel array of any preceding claim.

12. The imager of claim 11, wherein the imager is a CMOS imager and the pixel cells are CMOS pixel cells.

13. The imager of claim 11, further comprising a circuit for applying an operating signal to the common HDR/AB gate to control the draining of the charges.

14. The imager of claim 13, wherein the circuit is constructed to apply a global operating signal to each of a plurality of HDR/AB gates in the array.

15. A processing system comprising:
a processor; and
an imager of any one of claims 11-14.

16. A method of operating a pixel array comprising:
initiating a first integration period for each of a plurality of pixels in the array by operating a plurality of HDR/AB gates of a plurality of HDR/AB transistors simultaneously, wherein each of the HDR/AB gates is shared by four HDR/AB transistors respectively for four adjacent pixels;
allowing photosensors formed in the plurality of pixels to integrate photo-charges during the first integration period; and
ending the first integration period for the plurality of pixels by transferring the photo-charges generated by the photosensors into a respective storage region.

17. The method of claim 16, further comprising the act of initiating a second integration period; and the act of reading out a signal from at least one pixel representing the charges transferred at the end of the first integration period, during the second integration period.

18. The method of claim 16, further comprising the act of initiating a second integration period, wherein the act of initiating comprises activating the shared HDR/AB gate.

19. A method of operating a pixel array comprising:
integrating charge at first, second, third and fourth photosensors during a first charge integration period;
allowing excess generated charges to drain to a common drain region for the first, second, third and fourth photosensors during the first integration period; and
transferring the generated charges from the first, second, third and fourth photosensors to at least one storage node at the end of the first integration period.

20. The method of claim 19, wherein allowing charges to drain comprises operating a respective first, second, third and fourth HDR/AB transistors, the transistors sharing a common anti-blooming transistor gate.

21. The method of claim 19, further comprising the act of reading out a first and second signal representing the generated charges during a second integration period.

## Patentansprüche

1. Pixelmatrix (550), Folgendes umfassend:
einen ersten Lichtsensor zum Erzeugen von Ladung als Reaktion auf aufgebrachtes Licht;
einen zweiten Lichtsensor zum Erzeugen von Ladung als Reaktion auf aufgebrachtes Licht;
einen ersten und einen zweiten High-Dynamic-Range-/Anti-Blooming("HDR/AB")-Transistor, die mit dem ersten beziehungsweise dem zweiten Lichtsensor gekoppelt sind, um die erzeugten Ladungen aus den Lichtsensoren in einen gemeinsamen Drain-Bereich (528) abzuleiten, wobei die Transistoren ein gemeinsames HDR-/AB-Gate (518) aufweisen;
einen dritten Lichtsensor und einen vierten Lichtsensor zum Erzeugen entsprechender Ladungen als Reaktion auf aufgebrachtes Licht; und
einen dritten und einen vierten HDR-/AB-Transistor, die mit dem dritten beziehungsweise dem vierten Lichtsensor gekoppelt sind, um die erzeugten Ladungen von dem dritten und dem vierten Lichtsensor zu dem gemeinsamen Drain-Bereich (528) abzuleiten, wobei der dritte und der vierte HDR-/AB-Transistor das gemeinsame HDR-/AB-Gate (518) enthalten.

2. Pixelmatrix nach Anspruch 1, wobei sich wenigstens zwei der vier Lichtsensoren (501, 541; 503, 542) ein gemeinsames Transistor-Übertragungsgate (505; 507) zum Übertragen der erzeugten Ladungen an einen schwebenden Diffusionsbereich (520; 510) teilen.

3. Pixelmatrix nach Anspruch 2, wobei sich das gemeinsame Transistor-Übertragungsgate (506; 507) an einer Seite der wenigstens zwei Lichtsensoren (501, 541) gegenüber dem gemeinsamen HDR-/AB-Gate (518) befindet.

4. Pixelmatrix nach Anspruch 1, wobei der erste und der zweite Lichtsensor (501, 541; 503, 542) in einer ersten Reihe der Matrix reihenbenachbarte Lichtsensoren sind und wobei der dritte und der vierte Lichtsensor in einer zweiten Reihe der Matrix reihenbenachbarte Lichtsensoren sind.

5. Pixelmatrix nach Anspruch 1, wobei der erste, der zweite, der dritte und der vierte Lichtsensor mit einer ersten, einer zweiten, einer dritten beziehungsweise einer vierten Ausleseschaltung verknüpft sind.

6. Pixelmatrix, Folgendes umfassend:
eine Mehrzahl von Pixeln, die in Reihen und Spalten angeordnet sind, wobei die Mehrzahl Folgendes enthält:
erste, zweite, dritte und vierte Pixel mit einem ersten, einem zweiten, einem dritten beziehungsweise einem vierten Lichtsensor (501, 502, 503, 504) zum Erzeugen von Lichtladungen;
einen ersten, einen zweiten, einen dritten und einen vierten HDR-/AB-Transistor (518, 519, 522, 521) zum Ableiten von überschüssigen Lichtladungen von dem ersten, dem zweiten, dem dritten und dem vierten Lichtsensor in einen Drain-Bereich (528);
einen gemeinsamen Speicherknoten (520, 510) zum Speichern der erzeugten Lichtladungen; und
wenigstens einen gemeinsamen Transistor zum Auslesen eines Signals aus dem gemeinsamen Speicherknoten, das eine Menge von erzeugten Lichtladungen auf eine Spaltenleitung (580) darstellt.

7. Pixelmatrix nach Anspruch 6, ferner umfassend ein erstes, ein zweites, ein drittes und ein viertes Speichergate zum Übertragen erzeugter Ladungen von dem ersten, dem zweiten, dem dritten beziehungsweise dem vierten Lichtsensor in einen entsprechenden Speicherbereich.

8. Pixelmatrix nach Anspruch 7, ferner umfassend einen ersten, einen zweiten, einen dritten beziehungsweise einen vierten Transistor (505', 506', 507', 508') zum entsprechenden Übertragen von Ladungen von dem ersten, dem zweiten, dem dritten beziehungsweise dem vierten Speicherbereich in den gemeinsamen Speicherknoten.

9. Pixelmatrix nach Anspruch 6, ferner umfassend eine Ausleseschaltung, die wenigstens zwei Sätze von Kondensatoren (715, 716) zum Speichern von Signalausgängen auf der Spaltenleitung enthält.

10. Pixelmatrix nach Anspruch 8, ferner umfassend einen Schalter (712) zum Leiten eines ersten Signals in einen ersten Satz von Kondensatoren und eines zweiten Signals in einen zweiten Satz von Kondensatoren.

11. Bildgebungseinrichtung, umfassend eine Pixelmatrix nach einem der vorhergehenden Ansprüche.

12. Bildgebungseinrichtung nach Anspruch 11, wobei die Bildgebungseinrichtung eine CMOS-Bildgebungseinrichtung ist und die Pixelzellen CMOS-Pixelzellen sind.

13. Bildgebungseinrichtung nach Anspruch 11, ferner umfassend einen Schaltkreis zum Anlegen eines Betriebssignals an das gemeinsame HDR-/AB-Gate, um das Ableiten der Ladungen zu steuern.

14. Bildgebungseinrichtung nach Anspruch 13, wobei der Schaltkreis aufgebaut ist, um ein globales Betriebssignal an jedes von mehreren HDR-/AB-Gates in der Matrix anzulegen.

15. Verarbeitungssystem, Folgendes umfassend:
einen Prozessor; und
eine Bildgebungseinrichtung nach einem der Ansprüche 11-14.

16. Verfahren zum Betreiben einer Pixelmatrix, Folgendes umfassend:
Initiieren einer ersten Integrationszeit für jedes von mehreren Pixeln in der Matrix dadurch, dass mehrere HDR-/AB-Gates mehrerer HDR-/AB-Transistoren gleichzeitig betrieben werden, wobei jedes der HDR-/AB-Gates von vier HDR-/AB-Transistoren für jeweils vier aneinander angrenzende Pixel geteilt wird;
Ermöglichen, dass in den mehreren Pixeln gebildete Lichtsensoren während der ersten Integrationszeit Lichtladungen integrieren; und
Beenden der ersten Integrationszeit für die mehreren Pixel durch Übertragen der durch die Lichtsensoren erzeugten Lichtladungen in einen entsprechenden Speicherbereich.

17. Verfahren nach Anspruch 16, ferner umfassend die Handlung des Initiierens einer zweiten Integrationszeit; und die Handlung des Auslesens eines Signals von wenigstens einem Pixel, das die Ladungen, die am Ende der ersten Integrationszeit während der zweiten Integrationszeit übertragen wurden, darstellt.

18. Verfahren nach Anspruch 16, ferner umfassend die Handlung des Initiierens einer zweiten Integrationszeit, wobei die Handlung des Initiierens das Aktivieren des geteilten HDR-/AB-Gates umfasst.

19. Verfahren zum Betreiben einer Pixelmatrix, Folgendes umfassend:
Integrieren von Ladung an einem ersten, einem zweiten, einem dritten und einem vierten Lichtsensor während einer ersten Ladungsintegrationszeit;
Ermöglichen, dass überschüssig erzeugte Ladungen in einen gemeinsamen Drain-Bereich für den ersten, den zweiten, den dritten und den vierten Lichtsensor während der ersten Integrationszeit abgeleitet werden; und
Übertragen der erzeugten Ladungen von dem ersten, dem zweiten, dem dritten und dem vierten Lichtsensor auf wenigstens einen Speicherknoten am Ende der ersten Integrationszeit.

20. Verfahren nach Anspruch 19, wobei das Ermöglichen, dass Ladungen abgeleitet werden, umfasst, dass ein erster, ein zweiter, ein dritter beziehungsweise ein vierter HDR-/AB-Transistor betrieben wird, wobei die Transistoren sich ein gemeinsames Anti-Blooming-Transistor-Gate teilen.

21. Verfahren nach Anspruch 19, ferner umfassend die Handlung des Auslesens eines ersten und eines zweiten Signals, die die während einer zweiten Integrationszeit erzeugten Ladungen darstellen.

## Revendications

1. Matrice de pixels (550) comprenant :
un premier photocapteur pour générer une charge en réponse à une lumière appliquée ;
un deuxième photocapteur pour générer une charge en réponse à une lumière appliquée ;
des premier et deuxième transistors à gamme dynamique étendue/anti-éblouissement (« HDR/AB ») couplés respectivement aux premier et deuxième photocapteurs pour drainer les charges générées des photocapteurs vers une région de drain commune (528), lesdits transistors ayant une grille HDR/AB commune (518) ;
un troisième photocapteur et un quatrième photocapteur pour générer des charges respectives en réponse à une lumière appliquée ; et
des troisième et quatrième transistors HDR/AB couplés respectivement aux troisième et quatrième photocapteurs pour drainer les charges générées des troisième et quatrième photocapteurs vers ladite région de drain commune (528), lesdits troisième et quatrième transistors HDR/AB comportant ladite grille HDR/AB commune (518).

2. Matrice de pixels selon la revendication 1, dans laquelle au moins deux des quatre photocapteurs (501, 541 ; 503, 542) partagent une grille de transistor de transfert commune (505 ; 507) pour transférer lesdites charges générées vers une région de diffusion flottante (520 ; 510).

3. Matrice de pixels selon la revendication 2, dans laquelle la grille de transistor de transfert commune (506 ; 507) est située d'un côté des au moins deux photocapteurs (501, 541) opposés à la grille HDR/AB commune (518).

4. Matrice de pixels selon la revendication 1, dans laquelle les premier et deuxième photocapteurs (501, 541 ; 503, 542) sont des photocapteurs adjacents en rangée dans une première rangée de la matrice, et dans laquelle les troisième et quatrième photocapteurs sont des photocapteurs adjacents en rangée dans une seconde rangée de la matrice.

5. Matrice de pixels selon la revendication 1, dans laquelle les premier, deuxième, troisième et quatrième photocapteurs sont associés à des premier, deuxième, troisième et quatrième circuits de lecture respectifs.

6. Matrice de pixels comprenant :
une pluralité de pixels agencés en rangées et colonnes, la pluralité comportant :
des premier, deuxième, troisième et quatrième pixels ayant des premier, deuxième, troisième et quatrième photocapteurs (501, 502, 503, 504) respectifs pour générer des photo-charges ;
des premier, deuxième, troisième et quatrième transistors HDR/AB (518, 519, 522, 521) pour drainer un excédent de photo-charges des premier, deuxième, troisième et quatrième photocapteurs dans une région de drain (528) ;
un noeud de stockage commun (520, 510) pour stocker les photo-charges générées ; et
au moins un transistor commun pour lire un signal depuis le noeud de stockage commun représentant une quantité de photo-charges générées sur une ligne de colonne (580).

7. Matrice de pixels selon la revendication 6, comprenant en outre des première, deuxième, troisième et quatrième grilles de stockage pour transférer respectivement des charges générées des premier, deuxième, troisième et quatrième photocapteurs dans une région de stockage respective.

8. Matrice de pixels selon la revendication 7, comprenant en outre des premier, deuxième, troisième et quatrième transistors de transfert (505', 506', 507', 508') respectifs pour transférer respectivement des charges des première, deuxième, troisième et quatrième régions de stockage respectives dans le noeud de stockage commun.

9. Matrice de pixels selon la revendication 6, comprenant en outre un circuit de lecture qui comporte au moins deux jeux de condensateurs (715, 716) pour stocker des signaux fournis en sortie sur la ligne de colonne.

10. Matrice de pixels selon la revendication 8, comprenant en outre un commutateur (712) pour diriger un premier signal dans un premier jeu de condensateurs et un second signal dans un second jeu de condensateurs.

11. Imageur comprenant une matrice de pixels de l'une quelconque des revendications précédentes.

12. Imageur selon la revendication 11, dans lequel l'imageur est un imageur CMOS et les cellules de pixels sont des cellules de pixels CMOS.

13. Imageur selon la revendication 11, comprenant en outre un circuit pour appliquer un signal d'exploitation à la grille HDR/AB commune pour commander le drainage des charges.

14. Imageur selon la revendication 13, dans lequel le circuit est construit pour appliquer un signal d'exploitation global à chacune d'une pluralité de grilles HDR/AB dans la matrice.

15. Système de traitement comprenant :
un processeur ; et
un imageur de l'une quelconque des revendications 11 à 14.

16. Procédé d'exploitation d'une matrice de pixels comprenant :
le lancement d'une première période d'intégration pour chacun d'une pluralité de pixels dans la matrice en exploitant simultanément une pluralité de grilles HDR/AB d'une pluralité de transistors HDR/AB, dans lequel chacune des grilles HDR/AB est partagée par quatre transistors HDR/AB respectivement pour quatre pixels adjacents ;
le fait de permettre à des photocapteurs formés dans la pluralité de pixels d'intégrer des photo-charges pendant la première période d'intégration ; et
la fin de la première période d'intégration pour la pluralité de pixels en transférant les photo-charges générées par les photocapteurs dans une région de stockage respective.

17. Procédé selon la revendication 16, comprenant en outre l'acte de lancer une seconde période d'intégration ; et l'acte de lire un signal depuis au moins un pixel représentant les charges transférées à la fin de la première période d'intégration, pendant la seconde période d'intégration.

18. Procédé selon la revendication 16, comprenant en outre l'acte de lancer une seconde période d'intégration, l'acte de lancement comprenant l'activation de la grille HDR/AB partagée.

19. Procédé d'exploitation d'une matrice de pixels comprenant :
l'intégration d'une charge au niveau de premier, deuxième, troisième et quatrième photocapteurs pendant une première période d'intégration de charge ;
le fait de permettre à un excédent de charges générées de se drainer vers une région de drain commune pour les premier, deuxième, troisième et quatrième photocapteurs pendant la première période d'intégration ; et
le transfert des charges générées des premier, deuxième, troisième et quatrième photocapteurs vers au moins un noeud de stockage à la fin de la première période d'intégration.

20. Procédé selon la revendication 19, dans lequel le fait de permettre à des charges de se drainer comprend l'exploitation de premier, deuxième, troisième et quatrième transistors HDR/AB respectifs, les transistors partageant une grille de transistor anti-éblouissement commune.

21. Procédé selon la revendication 19, comprenant en outre l'acte de lire un premier et un second signal représentant les charges générées pendant une seconde période d'intégration.
